# DEMANDE DE BREVET EUROPEEN

(11) **EP 2 315 251 A1**
(43) Date de publication de la demande: **27.04.2011**
(21) Numéro de dépôt: 10188591.1
(22) Date de dépôt: 22.10.2010
(51) Int. Cl.: H01L 27/146

(54) **Capteur d'image à grille de transfert verticale et son procédé de fabrication**

(30) Priorité: 22.10.2009 FR 0957427
(71) Demandeur: STMicroelectronics (Crolles 2) SAS, 38920 Crolles (FR)
(72) Inventeur: Roy, François, 38180 Seyssins (FR); Barbier, Frédéric, 38000 Grenoble (FR)
(74) Mandataire: de Beaumont, Michel

(57) **Abrégé**

L'invention concerne un capteur d'image comprenant:
un premier pixel (401) disposé entre des deuxième et troisième pixels, chacun des premier, deuxième (402) et troisième (403) pixels comprenant une région de photodiode (404, 412, 416) entourée d'une tranchée isolée (406, 413, 417) ; une première grille de transfert de charge (424) comprenant une première électrode de colonne (426) entourée d'une couche d'isolement (428) disposée dans une ouverture (408) de la tranchée isolée entre les premier et deuxième pixels, la première électrode de colonne étant configurée pour recevoir un premier signal de tension de transfert ; et une deuxième grille de transfert de charge (425) comprenant une deuxième électrode de colonne (426) entourée d'une couche d'isolement (428) disposée dans une ouverture (410) de la tranchée isolée entre les premier et troisième pixels, la deuxième électrode de colonne étant configurée pour recevoir un deuxième signal de tension de transfert.

## Description

### Domaine de l'invention

La présente invention concerne un capteur d'image, et plus particulièrement un capteur d'image comprenant des pixels ayant une grille de transfert verticale.

### Arrière-plan de l'invention

Les capteurs d'image monolithiques comprennent des photodiodes et des transistors formés dans un substrat de silicium. Plus particulièrement, ces capteurs d'images comprennent un réseau de pixels dont chacun comporte une photodiode couplée à un noeud de détection par l'intermédiaire d'un transistor de transfert. La charge accumulée par la photodiode pendant une période d'intégration peut être transférée vers le noeud de détection par l'intermédiaire du transistor de transfert.

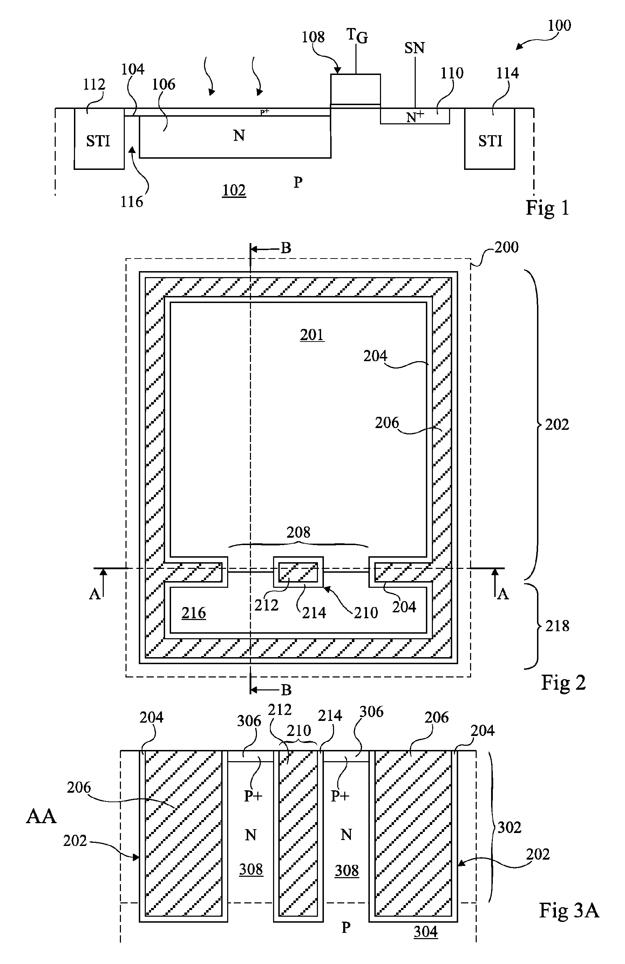

La figure 1 illustre un pixel 100 d'un capteur d'image formé dans un substrat de type P 102. Une photodiode du pixel comprend une couche 104 fortement dopée de type P formée sur un caisson de type N 106, formé dans le substrat de type P. Un transistor de transfert comprend un empilement de grille 108 formé sur la surface du substrat P 102 sur un côté de la photodiode. Un drain 110 est formé d'une région de type N fortement dopée, et est couplé à un noeud de détection SN. Des charges accumulées par la photodiode pendant une phase d'intégration peuvent être transférées vers le noeud de détection par l'application d'un signal de tension à l'électrode de grille du transistor de transfert.

Le pixel 100 est isolé des pixels adjacents sur chaque côté par des régions d'isolement à tranchée peu profonde (STI) 112, 114. Un espace 116 peut être prévu entre le STI 112 et le caisson de type N de la photodiode pour assurer la continuité électrique entre la couche de surface P+ (104) et le substrat P (102) et réduire le risque de génération d'un courant d'obscurité dans la photodiode.

Pour augmenter la sensibilité du capteur d'image et/ou réduire ses dimensions, il serait souhaitable d'augmenter la surface et la profondeur du caisson N 106. Cependant, on rencontre des problèmes pour augmenter la taille du caisson N 106 sans limiter la charge transférée, et/ou sans augmenter la taille du capteur d'image.

### Résumé de l'invention

Ainsi, un mode de réalisation de la présente invention prévoit un capteur d'image comprenant : un premier pixel disposé entre des deuxième et troisième pixels, chacun des premier, deuxième et troisième pixels comprenant une région de photodiode entourée d'une tranchée isolée ; une première grille de transfert de charge comprenant une première électrode de colonne entourée d'une couche d'isolement disposée dans une ouverture de la tranchée isolée entre les premier et deuxième pixels, la première électrode de colonne étant configurée pour recevoir un premier signal de tension de transfert ; et une deuxième grille de transfert de charge comprenant une deuxième électrode de colonne entourée d'une couche d'isolement disposée dans une ouverture de la tranchée isolée entre les premier et troisième pixels, la deuxième électrode de colonne étant configurée pour recevoir un deuxième signal de tension de transfert.

Selon un mode de réalisation, le capteur d'image comprend en outre : un premier noeud de collecte de charge associé à la première grille de transfert de charge pour collecter des charges stockées dans les régions de photodiode des premier et deuxième pixels ; et un deuxième noeud de collecte de charge associé à la deuxième grille de transfert de charge pour collecter des charges stockées dans les régions de photodiode des premier et troisième pixels.

Selon un mode de réalisation, au moins une partie de la tranchée isolée du premier pixel est commune aux premier et deuxième pixels.

Selon un mode de réalisation, l'ouverture entre les premier et deuxième pixels est formée dans une section commune de la tranchée isolée entre les premier et deuxième pixels.

Selon un mode de réalisation, le capteur d'image comprend en outre un bloc de commande configuré pour appliquer, pendant une phase de lecture du capteur d'image, le premier signal de tension de transfert à la première électrode de colonne pour transférer les charges stockées par les premier et deuxième pixels vers le premier noeud de collecte de charge avant d'appliquer le deuxième signal de tension de transfert à la deuxième électrode de colonne pour transférer les charges stockées par les deuxième et troisième pixels vers le deuxième noeud de collecte de charge.

Selon un mode de réalisation, le capteur d'image comprend en outre une autre grille de transfert de charge comprenant une autre électrode de colonne isolée par rapport à la deuxième région de photodiode et disposée dans une ouverture entre le deuxième pixel et une région de collecte de charge, l'autre électrode de colonne étant configurée pour recevoir une autre tension de transfert.

Selon un mode de réalisation, les régions de photodiode des premier, deuxième et troisième pixels comprennent une couche fortement dopée de type P formée sur une région de type N.

Selon un mode de réalisation, les tranchées isolées des premier, deuxième et troisième pixels sont remplies d'un matériau conducteur.

Selon un mode de réalisation, les tranchées des premier, deuxième et troisième pixels et les première et deuxième grilles de transfert de charge ont une profondeur comprise entre 1 et 10 µm.

Selon un mode de réalisation, chacun des premier et deuxième noeuds de collecte de charge est couplé à un noeud de détection commun de circuit de commande de pixel agencé pour lire un niveau de tension associé aux première et deuxième régions de photodiode.

Selon un mode de réalisation, le capteur d'image comprend un réseau desdits premier, deuxième et troisième pixels.

Un autre aspect de la présente invention prévoit un dispositif électronique de capture d'image comprenant le capteur d'image ci-dessus.

Un autre aspect de la présente invention prévoit un procédé de fabrication d'un capteur d'image comprenant un réseau de pixels, le procédé comprenant : former un premier pixel entre des deuxième et troisième pixels, chacun des premier, deuxième et troisième pixels comprenant une région de photodiode entourée d'une tranchée isolée ; former une première grille de transfert de charge comprenant une première électrode de colonne entourée d'une couche d'isolement disposée dans une ouverture de la tranchée isolée entre les premier et deuxième pixels, la première électrode de colonne étant configurée pour recevoir un premier signal de tension de transfert ; et former une deuxième grille de transfert de charge comprenant une deuxième électrode de colonne entourée d'une couche d'isolement disposée dans une ouverture de la tranchée isolée entre les premier et troisième pixels, la deuxième électrode de colonne étant configurée pour recevoir un deuxième signal de tension de transfert.

Selon un mode de réalisation, le procédé comprend en outre : former un premier noeud de collecte de charge associé à la première grille de transfert de charge pour collecter des charges stockées dans les régions de photodiode des premier et deuxième pixels ; et former un deuxième noeud de collecte de charge associé à la deuxième grille de transfert de charge pour collecter des charges stockées dans les régions de photodiode des premier et troisième pixels.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 (décrite précédemment) est une vue en coupe d'un pixel ;
la figure 2 est une vue de dessus d'un pixel selon un mode de réalisation ;
les figures 3A et 3B sont des vues en coupe du pixel de la figure 2 ;
la figure 4 est une vue de dessus d'un pixel selon un mode de réalisation de la présente invention ;
les figures 5A et 5B sont des vues en coupe du pixel de la figure 4 ;
les figures 5C et 5D sont des vues de dessus du pixel de la figure 4 ;
la figure 6 est une vue de dessus d'une partie d'un capteur d'image selon un mode de réalisation de la présente invention ;
la figure 7 illustre schématiquement un circuit de pixel selon un mode de réalisation de la présente invention ;
la figure 8 représente des signaux de synchronisation appliqués au circuit de la figure 7 selon un mode de réalisation de la présente invention ;
la figure 9 illustre schématiquement une partie d'un circuit de pixel selon une variante de réalisation de la présente invention ; et
la figure 10 illustre un dispositif électronique comprenant un capteur d'image selon des modes de réalisation de la présente invention.

### Description détaillée de modes de réalisation de la présente invention

La figure 2 est une vue de dessus d'un pixel 200 qui a été proposé par la présente demanderesse dans la demande de brevet française FR 08/52759 (aussi US N° 12/429 413).

Le pixel 200 comprend une région de photodiode rectangulaire 201, qui a par exemple une surface d'environ 1 µm², entourée d'une tranchée rectangulaire 202. La tranchée 202 est délimitée par une couche d'isolement 204, et comprend un coeur conducteur 206 en un matériau conducteur.

Il y a une ouverture 208 sur un côté de la tranchée rectangulaire. Une grille de transfert de charge 210 est positionnée approximativement au milieu de l'ouverture 208, et comprend une colonne rectangulaire, ayant par exemple la même épaisseur que la tranchée 202. La colonne 210 comprend un coeur conducteur 212 formant une électrode de grille entourée d'une couche d'isolement 214 formant une isolation de grille. L'ouverture 208 conduit à une région de collecte de charge 216, qui est entourée d'une extension rectangulaire 218 de la tranchée 202.

La figure 3A illustre la coupe A-A du pixel de la figure 2, passant par le côté de la tranchée rectangulaire 202 au niveau de l'ouverture 208 et de la colonne 210. Le pixel est formé par une couche de type N 302, d'une épaisseur comprise par exemple entre 1 et 8 µm, disposée sur un substrat de type P 304. La tranchée 202 s'étend par exemple sur la même profondeur que la colonne 210, qui est par exemple comprise entre 1 et 10 µm. La colonne 210 et/ou la tranchée 202 s'étendent par exemple sur une courte distance dans le substrat de type P. Dans la région de photodiode 201, une couche 306 fortement dopée de type P (P+) est formée sur la couche de type N 302, formant une caisson de type N 308.

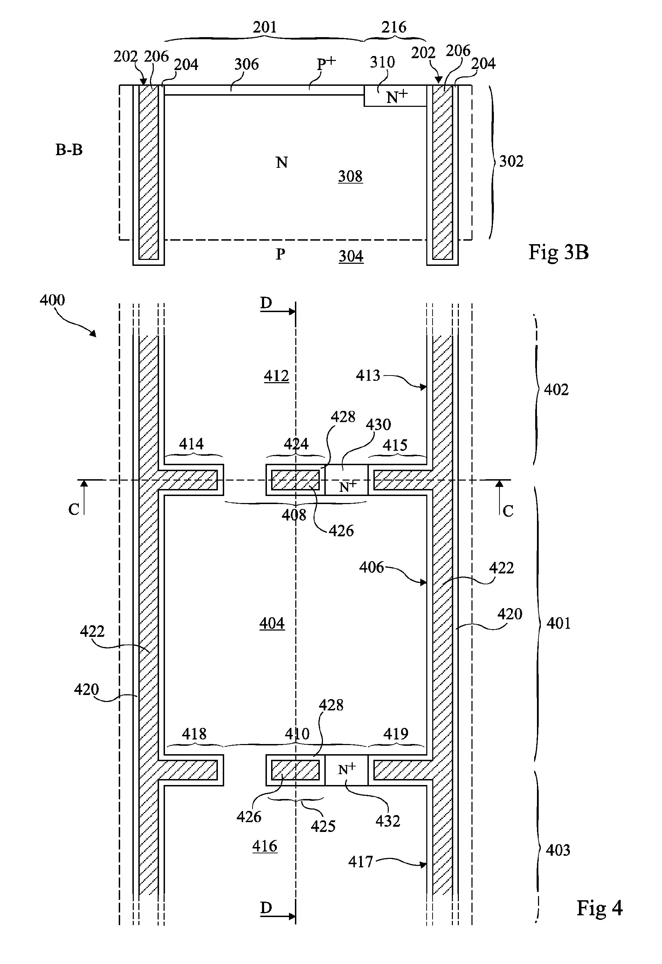

La figure 3B illustre la coupe B-B du pixel de la figure 2, qui est perpendiculaire à la coupe A-A, et passe à travers l'ouverture 208 sur un côté de la colonne 210. Comme cela est illustré, la couche de type N 302 s'étend de façon continue à partir de la région 201 jusqu'à la région 216 à travers l'ouverture 208, mais dans la région 216, une couche 310 fortement dopée de type N (N+) est formée sur le caisson N 308, avec par exemple une profondeur supérieure à celle de la couche P+ 306. Par exemple, la couche P+ 306 a une profondeur d'environ 0,1 µm et la couche N+ 310 a une profondeur d'environ 0,3 µm.

Un inconvénient du pixel de la figure 2 est que la région de collecte de charge 216 ne fait pas partie de la région de photodiode du dispositif, et donc limite le pourcentage de chaque pixel qui peut être utilisé pour la collecte et le stockage de charge.

La figure 4 illustre une partie 400 d'un capteur d'image comprenant un pixel 401, et des parties d'autres pixels 402 et 403 disposés de façon adjacente sur des côtés opposés du pixel 401. Le pixel 401 comprend une région de photodiode 404 entourée d'une tranchée rectangulaire 406, comportant des ouvertures 408 et 410 formées sur des côtés opposés. L'ouverture 408 est commune aux tranchées 406 et 413, et conduit de la région de photodiode 404 vers une région de photodiode 412 du pixel adjacent 402. La région de photodiode 412 est aussi entourée d'une tranchée rectangulaire 413, dont des parties 414 et 415 se trouvant de chaque côté de l'ouverture 408 sont communes avec la tranchée rectangulaire 406. En particulier, les tranchées rectangulaires 406 et 413 partagent un côté commun dans lequel est formée l'ouverture 408. L'ouverture 410 est commune aux tranches 406 et 417, et conduit de la région de photodiode 404 vers une région de photodiode 416 du pixel adjacent 403. La région de photodiode 416 est aussi entourée d'une tranchée rectangulaire 417, dont des parties 418 et 419 situées de chaque côté de l'ouverture 410 sont communes avec la tranchée rectangulaire 406. En particulier, les tranchées rectangulaires 406 et 417 partagent un côté commun dans lequel est formée l'ouverture 410.

Les tranchées 406, 413 et 417 sont des tranchées d'isolation profonde (en anglais "deep trench isolation", DTI), délimitées par une mince couche d'isolement 420, et comprenant un coeur conducteur 422 en un matériau conducteur. La couche d'isolement 420 isole électriquement le coeur conducteur 422 du silicium environnant.

Par exemple, la couche d'isolement 420 est formée en oxyde de silicium, en nitrure de silicium, en oxynitrure de silicium ou constituée d'une structure multicouche comprenant toute combinaison de ces matériaux, et a une épaisseur comprise entre 5 et 15 nm, par exemple, environ 7 nm. Le matériau conducteur 422 est par exemple du polysilicium, ayant par exemple une concentration en dopant supérieure à 10¹⁹ at./cm³. Les tranchées 406, 413 et 417 ont par exemple une épaisseur comprise entre 0,1 et 0,5 µm, et une profondeur comprise entre 1 et 10 µm. Dans des modes de réalisations alternatifs, les tranchées 406, 413 et 417 pourraient être des tranchées d'isolation profonde non-actives, comprenant uniquement un matériau isolant, par exemple un des matériaux isolants mentionnés ci-dessus pour la couche 420.

Dans chaque ouverture 408, 410, une colonne respective 424, 425 est formée avec une largeur comprise entre 0,1 et 0,4 µm, par exemple environ 0,3 µm, et une épaisseur approximativement égale à celle des tranchées 406, 413, 417. Les colonnes 424, 425 sont similaires à la colonne 210 de la figure 2, et forment des grilles de transfert de charge ayant un coeur conducteur 426 entouré d'une couche d'isolement 428 et isolé du silicium des régions de photodiode par celle-ci. Le coeur conducteur 426 et la couche d'isolement 428 sont par exemple formés des mêmes matériaux que le coeur conducteur 422 et la couche d'isolement 420 des tranchées 406, 413, 417, et forment des électrodes de grille et des isolations de grille respectivement des grilles de transfert de charge 424, 425.

Les ouvertures 408 et 410 ont, par exemple, des largeurs comprises entre 1/4 et 3/4 de la longueur des côtés dans lesquels elles sont formées. Par exemple, en supposant que chacune des tranchées 406, 413 et 417 forme un rectangle d'environ 1 µm², les largeurs des ouvertures 408 et 410 sont par exemple entre 0,25 µm et 0,75 µm, par exemple d'environ 0,5 µm. A titre de variante, les ouvertures 408, 410 pourraient s'étendre sur toute la largeur, les parties 414, 415, 418 et 419 étant enlevés. Dans ce cas, la largeur des colonnes 424, 425 pourrait être comprise entre 50% et 90% de la largeur des ouvertures 408, 410. Les colonnes 424, 425 pourraient aussi avoir d'autres formes. Par exemple, ils pourraient être fabriquées en forme de "T", de "+" ou de "H".

Alors que le pixel 200 de la figure 2 comprend une région de collecte de charge 216 entourée d'une tranchée, dans la structure de la figure 4, des noeuds de collecte de charge 430 et 432 sont formées de zones relativement petites d'un matériau fortement dopé de type N disposé dans les ouvertures 408, 410 respectivement, sur un côté de chacune des colonnes 424, 425. Ces régions forment effectivement des drains des transistors de transfert mis en oeuvre par les grilles de transfert de charge 424, 425. Par exemple, au moins un coté des noeuds de collecte de charge 430, 432 contacte la surface extérieure des colonnes 424, 425 respectivement, pour assurer le passage des charges entre les régions de photodiode et les noeuds de collecte de charge.

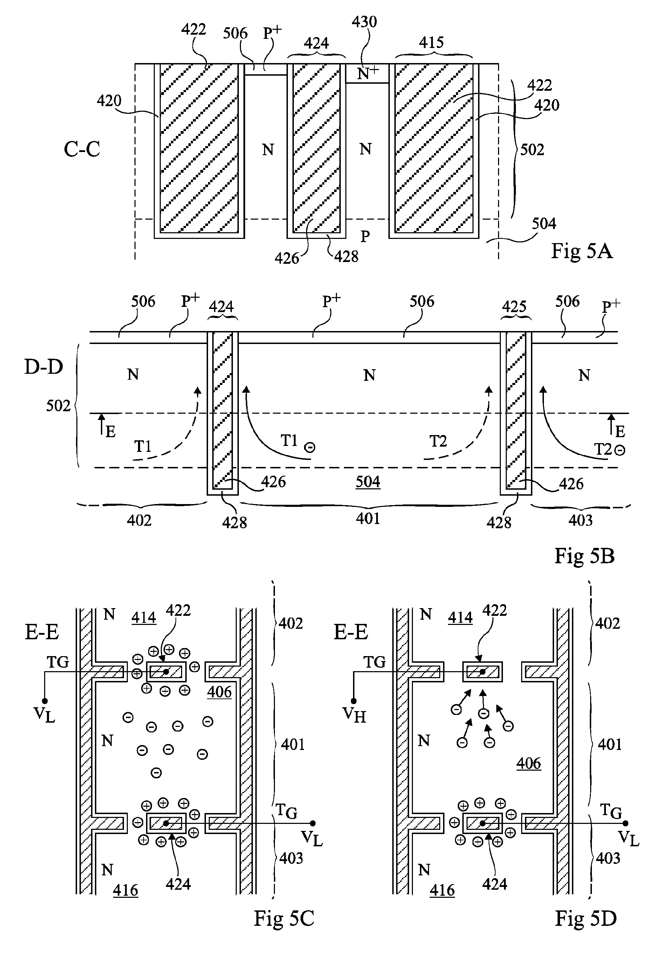

La figure 5A représente une coupe C-C de la structure de la figure 4, passant le long de la frontière entre les deux pixels 401 et 402, et passant à travers la colonne 424. La structure représentée par cette coupe C-C est similaire à la structure représentée par la coupe A-A du pixel 200, et comprend une couche 502 de silicium de type N formée, par exemple par épitaxie, sur un substrat de type P 504. Une couche 506 fortement dopée de type P est formée sur la couche de type N 502 dans les régions de photodiode 404, 412 et 416. La couche de type N 502 a par exemple une concentration en dopant comprise entre 10¹⁵ at./cm³ et 10¹⁷ at./cm³, et la couche P+ 506 a par exemple une concentration en dopant supérieure à 10¹⁸ at./cm³.

En outre, la région N+ 430 est représentée formée sur la couche de type N 502 dans l'intervalle compris entre la colonne 424 et la partie de tranchée 415. Le noeud de collecte de charge 430 contacte par exemple des couches d'isolement 420, 428 de chaque côté.

Les colonnes 424 et 425 et les tranchées 406, 413 et 417 s'étendent sur toute la profondeur de la couche de type N 502 et s'étendent aussi par exemple sur 0,1 à 2 µm dans le substrat 504. A titre de variante, les tranchées 406, 413, 417 et les colonnes 424, 425 ne pénètrent pas dans le substrat 504.

On va maintenant décrire le fonctionnement du capteur d'image de la figure 4 en référence aux figures 5B, 5C et 5D.

La figure 5B représente une coupe D-D de la structure de la figure 4, passant perpendiculairement à la coupe C-C, et traversant les deux colonnes 424 et 425. Dans cette vue, la couche de type N 502 formée sur le substrat de type P 504 est illustrée, avec la couche P+ 506.

Les figures 5C et 5D représentent toutes deux une coupe E-E de la figure 5B dans la couche de type N 502, et offrent ainsi des vues de dessus horizontales des caissons N du pixel.

Afin de contrôler l'accumulation de charge dans les photodiodes, et le transfert de charge vers les noeuds de collecte de charge, une tension de transfert TG est appliquée aux coeurs conducteurs 426 des colonnes 422, 424. En outre, une faible tension de polarisation est par exemple appliquée au coeur conducteur 422 des tranchées 406, 413 et 417. Par exemple, un niveau faible continu de cette tension de polarisation est appliqué pendant la phase d'intégration et pendant la phase de lecture à la fin de la phase d'intégration.

En référence à la figure 5C, pendant une phase d'intégration, TG est à une tension basse V_{L}, par exemple comprise entre 0 et -1 V. Cela entraîne une accumulation de trous autour des colonnes. De la lumière pénétrant dans la région de photodiode 406 pendant la phase d'intégration entraîne une accumulation d'électrons dans les caissons de type N des photodiodes. Ces électrons sont effectivement piégés, et ne vont pas se déplacer par les ouvertures 408, 410 vers les caissons N adjacents en raison des trous accumulés autour des colonnes 424, 425.

Comme cela est représenté en figure 5D, à la fin de la phase d'intégration du pixel 401, les charges accumulées sont transférées en appliquant une tension haute V_{H}, par exemple comprise entre 1 et 3 V, à la colonne 424, tout en maintenant la colonne 425 à la tension basse V_{L}. Cette séquence est représentée en figure 5B. Pendant un transfert T1, des électrons se trouvant dans le caisson N du pixel 401 sont conduits par l'intermédiaire d'un canal créé par la colonne 424 vers le noeud de collecte de charge 430 (non représenté dans la figure 5B). La charge du pixel 402 est par exemple transférée en premier, de sorte que lorsque le transfert T1 est effectué par l'intermédiaire de la colonne 424 pour vider le pixel 401, une très faible quantité de charge, voire aucune, est transférée à partir du caisson N du pixel 402, comme cela est représenté par la flèche en pointillés T1. De même, lorsqu'un transfert ultérieur est effectué pour le pixel 403, une très faible quantité de charge, voire aucune, est transférée à partir du pixel 401, puisque le caisson N du pixel 401 a déjà été vidé.

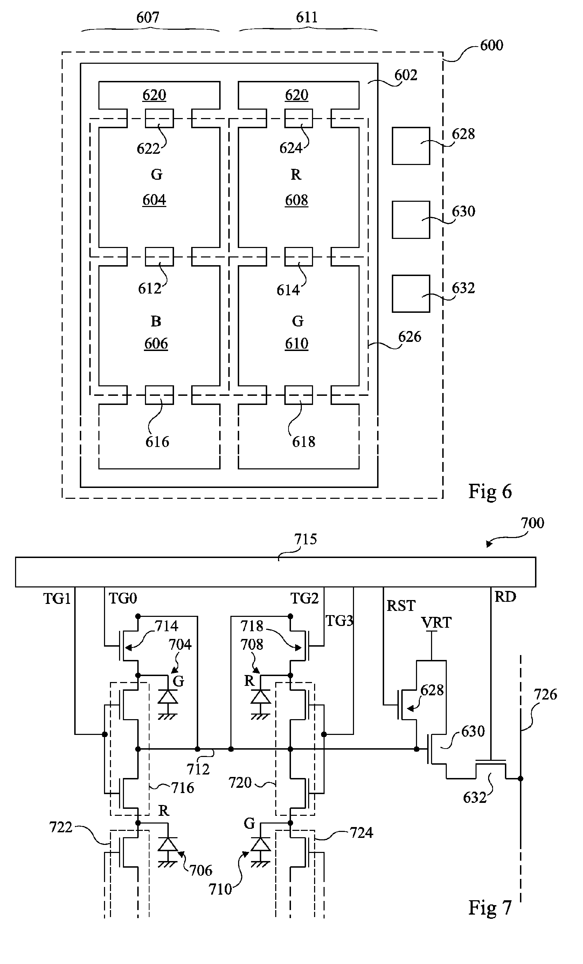

La figure 6 illustre une partie 600 d'un capteur d'image comprenant un réseau 602 de tranchées rectangulaires entourant des régions de photodiode de pixels formés dans des colonnes. Quatre pixels sont représentés, dont deux, 604, 606, sont agencés dans une colonne 607, et dont deux autres, 608, 610, sont agencés dans une colonne adjacente 611. Dans chaque colonne des pixels adjacents partagent des grilles de transfert de charge disposées dans des ouvertures communiquant entre eux. Par exemple, une grille de transfert de charge 612 est disposée entre les pixels 604 et 606, une grille de transfert de charge 614 est disposée entre les pixels 608 et 610, et des grilles de transfert de charge 616 et 618 sont disposées entre les pixels 606, 610 et les pixels suivants des colonnes respectives (non illustré en figure 6). Les grilles de transfert de charge 612, 614, 616 et 618 sont les mêmes que les grilles 424 et 425 décrites précédemment.

Les pixels 604 et 608 sont les premiers pixels de leurs colonnes respectives, et une région de collecte de charge 620 est formée à côté de chacun de ces pixels, de façon similaire à la région de collecte de charge 216 du pixel 200 de la figure 2. Les régions 620 communiquent avec les régions de photodiode des pixels 604, 608 par l'intermédiaire d'ouvertures respectives, dans lesquelles des grilles de transfert de charge 622, 624 sont formées, chacune étant similaire à la colonne 210 de la figure 2. Les grilles de transfert de charge 622, 624 et les régions de collecte de charge 620 correspondantes ne permettent que le transfert de la seule charge présente dans les pixels 604 et 608, ces pixels étant les premiers à être vidés au début d'une phase de transfert du capteur d'image.

L'extrémité du pixel final de chaque colonne ne comporte pas de grille de transfert de charge, ces pixels finaux ne partageant une grille de transfert de charge qu'avec un seul pixel adjacent. Bien que cela ne soit pas illustré en figure 6, il peut y avoir des centaines ou des milliers de pixels dans chaque colonne 607, 611. En outre, le capteur d'image peut comprendre des centaines ou des milliers de colonnes similaires aux colonnes 607, 611.

Par exemple, un filtre de Bayer est disposé sur le capteur d'image de la figure 6, dont une partie est représenté par la ligne en pointillés 626. Les pixels 604 et 610 sont par exemple associés à des filtres verts, de sorte qu'ils capturent de la lumière verte, tandis que les pixels 606 et 608 sont par exemple associés à des filtres respectifs bleu et rouge, de sorte qu'ils capturent de la lumière bleu et rouge. Les quatre pixels 604 à 610 forment par exemple ensemble un motif spécifique de séparation des couleurs du capteur d'image.

Un transistor de remise à zéro 628, un transistor à source suiveuse 630 et un transistor de lecture 632 sont formés dans le capteur d'image à côté de la colonne 611, et effectuent par exemple la fonction de lecture des tensions dans les pixels 604, 606, 608 et 610, comme cela va être décrit maintenant en référence à la figure 7.

La figure 7 illustre schématiquement un circuit de pixel 700 destiné à la lecture des quatre pixels 604 à 610 de la figure 6.

Le circuit 700 comprend des photodiodes 704, 706, 708 et 710 correspondant aux régions de photodiode des pixels 604, 606, 608 et 610 respectivement de la figure 6. Chacune de ces photodiodes 704 à 710 a son anode couplée à la masse, et sa cathode couplée à un noeud de détection 712 par l'intermédiaire d'une paire de transistors mis en oeuvre par les grilles de transfert de charge situées entre les pixels.

En particulier, un transistor 714 correspond à la grille de transfert de charge 622 de la figure 6, et le noeud de grille du transistor 714, qui correspond au coeur conducteur de la grille de transfert de charge 622, est couplé à un bloc de commande 715 pour recevoir un signal de tension de transfert TGO. En outre, une paire de transistors 716 correspond à la grille de transfert de charge 612 de la figure 6, le premier de la paire couplant la photodiode 704 au noeud de détection 712, et l'autre couplant la photodiode 706 au noeud de détection 712. Les noeuds de grille des transistors 716 reçoivent le signal de tension de transfert TG1 provenant du bloc de commande 715.

De façon similaire, un transistor 718 correspond à la grille de transfert de charge 624 de la figure 6, et le noeud de grille du transistor 718 est couplé au bloc de commande 715 pour recevoir un signal de tension de transfert TG2. En outre, une paire de transistors 720 correspond à la grille de transfert de charge 614 de la figure 6, le premier de la paire couplant la photodiode 708 au noeud de détection 712, et l'autre couplant la photodiode 710 au noeud de détection 712. Les noeuds de grille des transistors 720 reçoivent le signal de tension de transfert TG3 provenant du bloc de commande 715.

D'autres transistors 722, 724 correspondent aux grilles de transfert de charge 616, 618 de la figure 6 respectivement, couplant une photodiode respective 706, 710 au noeud de détection d'un circuit de pixel séparé (non représenté en figure 7). Les transistors 722, 724 ne sont activés qu'une fois que la charge provenant des photodiodes 706, 710 a été transférée vers le noeud de détection 712.

Le noeud de détection 712 est couplé au noeud de grille du transistor à source suiveuse 630, qui a sa source couplée à une ligne de colonne de lecture 726 par l'intermédiaire du transistor de lecture 632, et son noeud de drain couplé à une tension d'alimentation VRT. Le noeud de grille du transistor de lecture 632 est couplé pour recevoir une tension de lecture RD provenant du circuit de commande 715. Le noeud de détection 712 est aussi couplé à la tension d'alimentation VRT par l'intermédiaire du transistor de remise à zéro 628, qui reçoit au niveau de son noeud de grille un signal de remise à zéro RST.

Bien que le circuit de la figure 7 s'applique à quatre pixels agencés dans un bloc 2x2 telle que les pixels 604, 606, 608 et 610 de la figure 6, le circuit pourrait être adapté à quatre pixels agencés en colonne ou en ligne, dans une structure 1x4 ou 4x1.

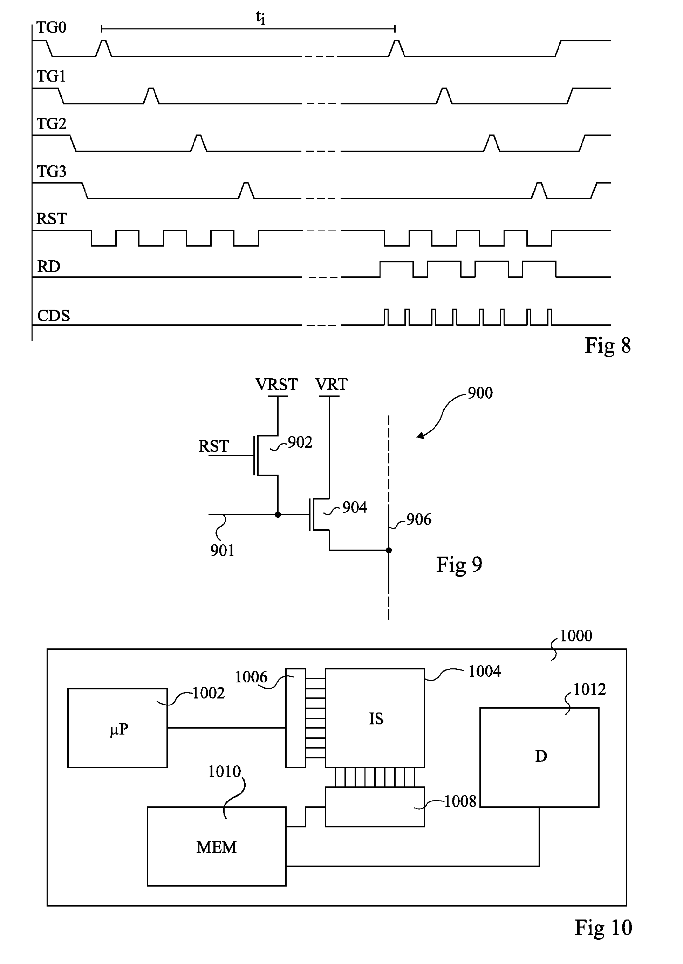

Le fonctionnement du circuit de la figure 7 va maintenant être décrit en référence aux chronogrammes de la figure 8.

Initialement, les signaux de tension de transfert TG0 à TG3 sont tous à l'état haut et la tension de remise à zéro RST est aussi à l'état haut, de sorte que les photodiodes sont vidées de leur charge et donc remises à zéro.

Pour commencer les périodes d'intégration des pixels, les signaux de tension de transfert TG0 à TG3 sont ensuite amenés à l'état bas l'un après l'autre, isolant ainsi les photodiodes correspondantes du noeud de détection 712. Peu de temps après le passage à l'état bas du signal TG0, le signal de remise à zéro est aussi amené à l'état bas. La tension de transfert TG0 est ensuite amenée à l'état haut pendant une courte durée, et une deuxième lecture du noeud de détection est faite, pour lire une deuxième tension de référence, et déterminer ainsi le décalage de charge résultant d'une lecture. La tension de grille de transfert TG0 est alors amenée de nouveau à l'état bas, commençant une période d'intégration ti de la photodiode 704.

On utilise ensuite la même séquence pour démarrer les périodes d'intégration de chacune des autres photodiodes 706, 708 et 710 tour à tour.

La phase de transfert et de lecture de la photodiode est mise en oeuvre de la façon suivante. A la fin de la période d'intégration ti de la photodiode 704, le signal de lecture RD est mis à l'état haut, le signal de remise à zéro RST est mis à l'état bas, et la tension de transfert TG0 est mise à l'état haut pour une courte durée, de sorte que la charge est transférée à partir de la photodiode 704 vers le noeud de détection SN. Comme cela est représenté par le signal CDS (en anglais "Correlated double sampling"), une lecture est effectuée peu de temps avant que TG0 passe à l'état haut, et peu de temps après TG0 repasse à l'état bas, la différence entre les tensions lues indiquant la chute de tension résultant de la charge accumulée pendant la période d'intégration. En particulier, les niveaux avant et après un transfert de charge vers le noeud de détection sont mémorisés dans deux condensateurs d'échantillonnage, puis une soustraction numérique ou analogique est appliquée aux signaux stockés pour déterminer le signal sans dispersion lié à la tension de seuil Vₜ et au bruit kTC, où k est la constante de Boltzmann, T est la température, et C est une capacitance. La tension au niveau du noeud de détection est ensuite remise à zéro par l'application du signal de remise à zéro RST, qui est amené de nouveau à l'état bas avant de lire la tension au niveau de la photodiode 706. La séquence de lecture continue de cette façon pour les autres photodiodes.

La séquence représentée en figure 8 correspond à la séquence de lecture d'un groupe de pixels couplé à un noeud de détection commun d'un circuit de pixel. Cette séquence est par exemple répétée pour tous les circuits de pixel du capteur d'image, pour réaliser une obturation continue (en anglais "rolling shutter").

Alors que le circuit de la figure 7 est d'un type 1T75 (quatre grilles de transfert de charge et trois autres transistors, et quatre photodiodes), les pixels décrits ici pourraient être utilisés également dans d'autres types de circuits de pixel, comme des circuits 1T5, 2T, 2T5 ou encore 4T. Dans le cas d'une architecture 4T, une seule diode est connectée sur un système de lecture comprenant trois transistors tels que les transistors 628, 630 et 632 de la figure 7.

La figure 9 illustre une circuiterie de lecture 900 d'un circuit de pixel correspondant par exemple à un type de circuit de pixel 2T. Ainsi, le noeud de détection 902 est par exemple couplé à deux des pixels tels que décrits ci-dessus.

Dans la circuiterie de lecture 900, un noeud de détection 901 est couplé à une tension de remise à zéro VRST par un transistor de remise à zéro 902, et au noeud de grille d'un transistor de lecture 904, qui est couplé entre une autre tension d'alimentation VRT et une ligne de lecture de colonne 906. Dans ce circuit, la lecture est effectuée en appliquant la tension VRST pendant une remise à zéro, et en transférant ensuite une charge de photodiode vers le noeud de détection 901, qui peut alors être lu sur une ligne 906.

La figure 10 illustre un dispositif électronique 1000, comprenant un microprocesseur 1002 et un capteur d'image 1004 comprenant par exemple un réseau de pixels tels que décrits ici, et associé à un circuit de commande 1006, qui produit les signaux RST, TG et RD pour la commande des circuits de pixels du capteur d'image. Une circuiterie de lecture 1008 est aussi couplée au capteur d'image, comprenant par exemple des commutateurs et des condensateurs pour échantillonner et mémoriser des valeurs de tension lues sur les lignes de lecture de colonne du capteur d'image 1004. Une mémoire 1010 mémorise par exemple des images capturées par le capteur d'image, et un afficheur 1012 affiche par exemple des images capturées.

Le dispositif électronique 1000 est par exemple un appareil photographique et/ou une caméra vidéo, un dispositif mobile ou une console de jeu portable ayant des fonctionnalités de capture d'image, une caméra adaptée à fonctionner sur Internet, un ordinateur portable ou un autre dispositif de capture d'image numérique ayant un capteur d'image apte à capturer des images fixes et/ou des images vidéo.

Un avantage des modes de réalisation décrits ici est que les pixels ont un pourcentage élevé de leur surface qui réalise la fonction d'une photodiode, et un pourcentage relativement faible de leur surface qui réalise la fonction du transistor de transfert. Ainsi, le capteur d'image peut avoir une plus grande sensibilité et/ou occuper une plus petite surface sur une puce.

Bien que la présente invention ait été décrite en relation avec un certain nombre de modes de réalisation particuliers, l'homme de l'art notera que divers changements et divers modifications peuvent être appliqués.

Par exemple, bien qu'un exemple de tracé ait été décrit en figure 6, avec un schéma de circuit tel qu'illustré en figure 7, il existe d'autres agencements possibles. Par exemple, plutôt que d'être formés en colonnes, les pixels peuvent être formés en rangées, avec des colonnes de transfert de charge disposées entre des pixels de la même rangée. De plus, les colonnes de transfert de charge pourraient avoir d'autres formes que celles décrites précédemment, par exemple s'étendant sur toute la largeur du pixel jusqu'au coté adjacent, et même intégrant une partie du coté adjacent.

En outre, chaque circuit de pixel pourrait être couplé à un groupe de pixels différent du groupe de pixels représenté en figure 6.

En outre, tandis que des modes de réalisations ont été décrits dans lesquels chaque pixel est entouré par une tranchée d'isolation profonde active, dans des modes de réalisation alternatifs, la tranchée d'isolation profonde peut être non-active, par exemple comprenant uniquement une couche isolante.

## Revendications

1. Capteur d'image comprenant :
un premier pixel (401) disposé entre des deuxième et troisième pixels, chacun des premier, deuxième et troisième pixels comprenant une région de photodiode (404, 412, 416) entourée d'une tranchée isolée (406, 413, 417) ;
une première grille de transfert de charge (424) comprenant une première électrode de colonne (426) entourée d'une couche d'isolement (428) disposée dans une ouverture (408) de la tranchée isolée entre les premier et deuxième pixels, la première électrode de colonne étant configurée pour recevoir un premier signal de tension de transfert ; et
une deuxième grille de transfert de charge (425) comprenant une deuxième électrode de colonne (426) entourée d'une couche d'isolement (428) disposée dans une ouverture (410) de la tranchée isolée entre les premier et troisième pixels, la deuxième électrode de colonne étant configurée pour recevoir un deuxième signal de tension de transfert.

2. Capteur d'image selon la revendication 1, comprenant :
un premier noeud de collecte de charge (430) associé à la première grille de transfert de charge pour collecter des charges stockées dans les régions de photodiode des premier et deuxième pixels ; et
un deuxième noeud de collecte de charge (432) associé à la deuxième grille de transfert de charge pour collecter des charges stockées dans les régions de photodiode des premier et troisième pixels.

3. Capteur d'image selon la revendication 1 ou 2, dans lequel au moins une partie (414, 415) de la tranchée isolée du premier pixel est commune aux premier et deuxième pixels.

4. Capteur d'image selon l'une quelconque des revendication 1 à 3, dans lequel l'ouverture (408) entre les premier et deuxième pixels est formée dans une section commune de la tranchée isolée entre les premier et deuxième pixels.

5. Capteur d'image selon l'une quelconque des revendications 1 à 4, comprenant en outre un bloc de commande (715) configuré pour appliquer, pendant une phase de lecture du capteur d'image, le premier signal de tension de transfert (TG1) à la première électrode de colonne pour transférer les charges stockées par les premier et deuxième pixels vers le premier noeud de collecte de charge avant d'appliquer le deuxième signal de tension de transfert (TG2) à la deuxième électrode de colonne pour transférer les charges stockées par les deuxième et troisième pixels vers le deuxième noeud de collecte de charge.

6. Capteur d'image selon l'une quelconque des revendications 1 à 5, comprenant en outre une autre grille de transfert de charge (622) comprenant une autre électrode de colonne isolée par rapport à la deuxième région de photodiode et disposée dans une ouverture entre le deuxième pixel et une région de collecte de charge (620), l'autre électrode de colonne étant configurée pour recevoir une autre tension de transfert (TGO).

7. Capteur d'image selon l'une quelconque des revendications 1 à 6, dans lequel les régions de photodiode des premier, deuxième et troisième pixels comprennent une couche fortement dopée de type P formée sur une région de type N.

8. Capteur d'image selon l'une quelconque des revendications 1 à 7, dans lequel les tranchées isolées des premier, deuxième et troisième pixels sont remplies d'un matériau conducteur.

9. Capteur d'image selon l'une quelconque des revendications 1 à 8, dans lequel les tranchées des premier, deuxième et troisième pixels et les première et deuxième grilles de transfert de charge ont une profondeur comprise entre 1 et 10 µm.

10. Capteur d'image selon la revendication 9, dans lequel chacun des premier et deuxième noeuds de collecte de charge est couplé à un noeud de détection commun de circuit de commande de pixel (616, 614, 618) agencé pour lire un niveau de tension associé aux première et deuxième régions de photodiode.

11. Capteur d'image selon l'une quelconque des revendications 1 à 10, comprenant un réseau desdits premier, deuxième et troisième pixels.

12. Dispositif électronique de capture d'image comprenant le capteur d'image selon l'une quelconque des revendications 1 à 11.

13. Procédé de fabrication d'un capteur d'image comprenant un réseau de pixels, le procédé comprenant :
former un premier pixel (401) entre des deuxième et troisième pixels, chacun des premier, deuxième et troisième pixels comprenant une région de photodiode (404, 412, 416) entourée d'une tranchée isolée (406, 413, 417) ;
former une première grille de transfert de charge (424) comprenant une première électrode de colonne (426) entourée d'une couche d'isolement (428) disposée dans une ouverture (408) de la tranchée isolée entre les premier et deuxième pixels, la première électrode de colonne étant configurée pour recevoir un premier signal de tension de transfert ; et
former une deuxième grille de transfert de charge (425) comprenant une deuxième électrode de colonne (426) entourée d'une couche d'isolement (428) disposée dans une ouverture (410) de la tranchée isolée entre les premier et troisième pixels, la deuxième électrode de colonne étant configurée pour recevoir un deuxième signal de tension de transfert.

14. Procédé selon la revendication 13, comprenant en outre :
former un premier noeud de collecte de charge (430) associé à la première grille de transfert de charge pour collecter des charges stockées dans les régions de photodiode des premier et deuxième pixels ; et
former un deuxième noeud de collecte de charge (432) associé à la deuxième grille de transfert de charge pour collecter des charges stockées dans les régions de photodiode des premier et troisième pixels.
